Europäisches Patentamt

European Patent Office

Office européen des brevets

(11) Publication number: **0 214 080**
**A2**

## (12) EUROPEAN PATENT APPLICATION

(21) Application number: **86630124.5**

(22) Date of filing: **07.08.86**

(51) Int. Cl.⁴: **C 30 B 11/00**
**C 30 B 29/52**

(30) Priority: **16.08.85 US 766854**

(43) Date of publication of application:
**11.03.87 Bulletin 87/11**

(84) Designated Contracting States:
**BE DE FR GB SE**

(71) Applicant: **UNITED TECHNOLOGIES CORPORATION**
**United Technologies Building 1, Financial Plaza**
**Hartford, CT 06101(US)**

(72) Inventor: **Aigeltinger, Edward H.**
**400 A North Flagler Drive**
**Palm Beach Florida 33401(US)**

(72) Inventor: **Reynolds, Paul L.**
**2450 Hope Lane**
**Lake Park Florida 33410(US)**

(72) Inventor: **Macrae, Robert A.**
**110 Banyan Circle**
**Jupiter Florida 33458(US)**

(74) Representative: **Schmitz, Jean-Marie**
**OFFICE DENNEMEYER S.à.r.l. P.O. Box 1502**
**L-1015 Luxembourg(LU)**

(54) Reduction of twinning in directional recrystallization of nickel base superalloys.

(57) The density of twins resulting from directional recrystallization of nickel base superalloys can be substantially reduced by the addition of a small but critical amount of boron to the material prior to the directional recrystallization step. From about .010 to about .015% boron by weight will reduce twin density without adversely affecting other material properties.

FIG.2

50 X

EP 0 214 080 A2

- 1 -

Description

Reduction Of Twinning In Directional
Recrystallization of Nickel Base Superalloys

Technical Field

This invention relates to improvements in the directional recrystallization of nickel base superalloy materials and to improved nickel base superalloy compositions for directional recrystallization.

Background Art

The directional recrystallization process is performed by conditioning a superalloy in order to render it susceptible to recrystallization. Recrystallization is accomplished by passing the article through a thermal gradient, the hot end of which exceeds the gamma prime solvus temperature, in order to cause recrystallization to occur progressively and selectively through the part. When performed under the proper conditions, such a process can produce a single crystal article of high perfection. When less stringent conditions are obeyed the process can produce an article comprised of many elongated grains whose direction of elongation is identical to the direction of passage of the thermal gradient. In addition, the elongated grains have similar crystallographic orientations. In either case, the resultant material has improved high temperature mechanical properties.

A recently appreciated problem encountered in the directional recrystallization of nickel base superalloys is that of twinning. Twinning is a metallurgical phenomenon in which independent crystals having a different crystal orientation spontaneously form during the recrystallization process. The relationship between the twin and the apparent single crystal is a fixed one and the formation of twins can be explained crystallographically based on grain boundary energies. The difference in crystal orientation renders the twin effectively an inhomogeneity within the parent crystal which can be the site of failure initiation. For this reason, twin formation is a limiting factor in the utility of directional recrystallization in the field of nickel base superalloys.

The nickel base superalloy field is a well developed one and hundreds of patents have issued on various aspects of nickel base superalloy art.

Boron is a fairly common constituent in nickel base superalloys and serves a variety of functions. It chiefly appears to segregate to the grain boundaries of the material and is found to increase the ductility of materials by preventing premature grain boundary related failure.

Reissue Patent 29,920 focuses on boron as an important superalloy constituent suggesting that it be added in amounts from about .05 to about 3% by weight to enhance the creep rupture strength of the material. This patent deals with superalloys which are used in final cast form and says nothing about superalloys which are treated in a solid state by controlled, directional recrystallization to develop enhanced properties.

U. S. Patent 4,359,352 suggests the addition of relatively large amounts of boron to superalloys which are subsequently attritted to powder. The boron addition serves to embrittle the material and assist in the attrition of the material. Additionally, the boron content is claimed to generally assist in developing material properties.

U. S. Patent 4,207,098 suggests the addition of large amounts of boron ranging from about .3 to about 1.2% by weight to improve the mechanical properties.

U. S. Patent 4,175,953 employs from about .2 to about 1.2% boron in a composition which is intended for use in dental prosthesis where high temperature strength is not required. The boron apparently improves bonding between the metal alloy and porcelain overlay components.

Use of boron in ranges of from about .001 to about .1% by weight in superalloys is common.

The subject of directional recrystallization (also alternatively referred to as directional grain growth) is the subject of several chapters in the book "The Art and Science of Growing Crystals" by J. J. Gilman, Wiley Publishing Company, 1963.

U. S. Patent 3,975,219 to Allen et al gives extensive background on the subject of directional recrystallization as it can be applied to superalloys. The patent describes the directional recrystallization of alloys containing 0.010-0.020% B but does not discuss twinning.

U. S. Patent 4,318,753 describes a heat treatment and resultant microstructure for nickel base superalloys which renders them particularly suited for subsequent directional recrystallization (or directional grain growth). This patent also presents information on the directional recrystallization of boron-containing materials without appreciating the significance of boron.

U. S. Patent 4,475,980 describes the solid state production of multiple single crystal articles by directional recrystallization. These latter three referenced patents are all incorporated herein by reference.

Disclosure of Invention

According to the present invention such twinning can be greatly reduced by adding small, controlled, amounts of boron to the superalloy composition.

The foregoing and other objects, features and advantages of the present invention will become more apparent from the following description of the best mode for carrying out the invention and the accompanying drawings.

Brief Description of Drawings

Fig. 1 illustrates the microstructure of a directionally recrystallized nickel base superalloy containing about 0.005% boron.

Fig. 2 illustrates the microstructure of a directionally recrystallized nickel base superalloy containing 0.011% boron.

Fig. 3 illustrates the microstructure of a directionally recrystallized nickel base superalloy containing 0.026% boron.

Best Mode for Carrying Out the Invention

The invention is generally applicable throughout the field of nickel base superalloys (which can be defined for the purposes of this application as those nickel base alloys which contain at least 5% chromium and which are strengthened by the gamma prime phase which results from the presence of aluminum and/or titanium in the alloy; other elements, particularly refractory metals are generally present for further strengthening). In particular, we believe that the present invention will find application in superalloys having the following compositions.

## TABLE 1

| | | | |
|---|---|---|---|
| 3% | to | 7.2% | Al |
| up | to | 1.0% | Ti |
| up | to | 10.0% | W |
| up | to | 12.0% | Mo |
| up | to | 9.0% | Ta |
| up | to | 1.0% | Cb |
| up | to | 5.0% | Co |
| 5.0% | to | 12.0% | Cr |
| up | to | 0.5% | Hf |
| up | to | 0.05% | Y |
| up | to | 0.01% | C |
| 0.010% | to | 0.015% | B |
| up | to | 0.010% | Zr |
| 5.0% | to | 15.0% | (W+Mo+Ta+Cb) |
| Balance essentially | | | Ni |

We have found that adding from about .010 to about .015% boron to this class of alloys will reduce the incidence of twinning by about 90%. Less than about 0.010% boron is ineffective in reducing the incidence of twinning while more than about 0.015% results in the presence of boride phases which melt during the directional recrystallization process. Thus, the boron level which will produce the necessary reduction in twin density can be alternatively described as from about .010 to about .015% or from .010 boron up to the boron level which will cause evolution of boride phases. The latter description is probably a better description since the amount of boron which may amount of boron which may produce boride phases may vary somewhat with the overall alloy composition, and since the absence or presence of boride phases is readily determined by metallographic examination.

It is hypothesized that boron changes the relationship between the energy of normal grain boundaries and the energy of twin boundaries in such a way that the formation of twins, during recrystallization, becomes energetically unfavorable.

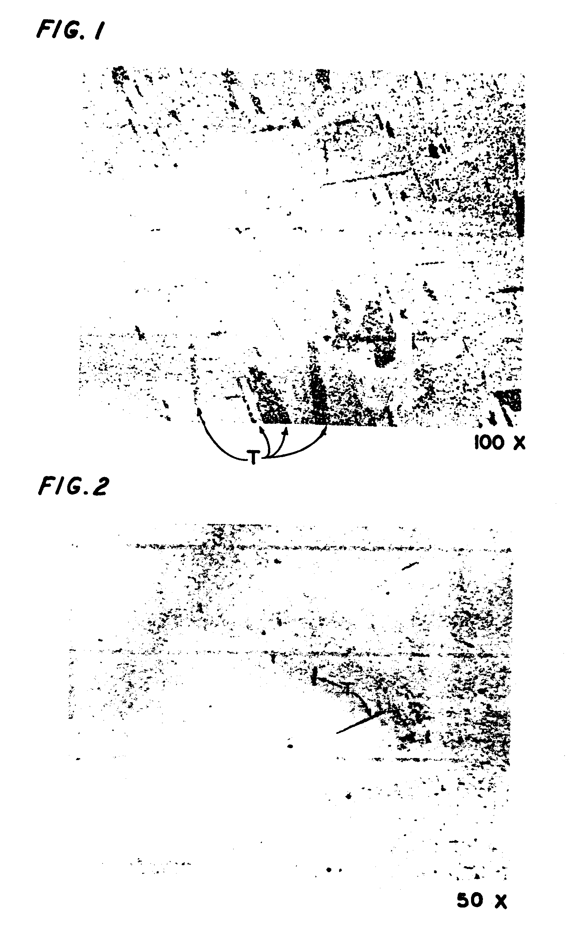

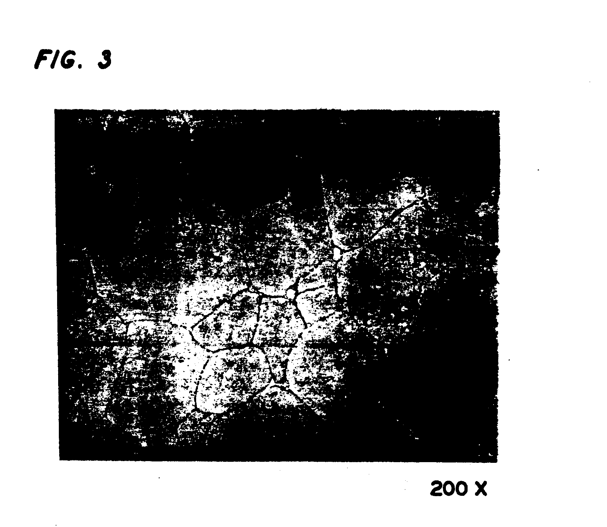

Figures 1-3 clearly illustrate the power of boron in affecting twin density. Figures 1-3 are all of a nickel base superalloy having a nominal composition of 6.9% Al, 9.8% W, 1.02% Mo, 2.3% Ta, 8.8% Cr, 0.16% Hf, 0.064% Y, 0.005% C, 0.03% Zr, balance nickel. Figure 1 shows this alloy with about 0.005% boron. Twins are illustrated as "T" and it can be seen that twins are quite common. Adding about 0.011% boron to the same alloy is seen to radically reduce the twin density while adding about 0.026% boron to the material results in a second phase, a boride phase, which is seen to have been the site of incipient melting during directional recrystallization.

The efficacy of boron in reducing twin density in directionally recrystallized material appears to be basically independent of the specific details of the directional recrystallization process which is employed. Insofar as we know, the best starting microstructure for directional recrystallization is that which is described in U. S. Patent 4,318,753 which is produced by the method described in the same patent. This patent, U. S. 4,318,753, is expressly incorporated herein by reference.

Having achieved a microstructure which is suited for directional recrystallization, directional recrystallization can be performed using the teachings of U. S. Patent 4,318,753 or 4,475,980 which are also incorporated herein by reference.

Accordingly, what has been described is a method for substantially reducing the incidence of detrimental twinning during the directional recrystallization of nickel base superalloys by adding a relatively small amount of boron to the material.

Although this invention has been shown and described with respect to a preferred embodiment, it will be understood by those skilled in this art that various changes in form and detail thereof may be made without departing from the spirit and scope of the claimed invention.

Claims

1.    Method of substantially reducing the incidence of twinning during the directional recrystallization of nickel base superalloys which comprises:
incorporating from about 0.010 to about 0.015% boron into the alloy to be directionally recrystallized.

2.    In the method of directionally recrystallizing nickel base superalloys the improvement which comprises:
incorporating from about 0.010 to about 0.015% boron in the alloy to be directionally recrystallized, whereby the incidence of twinning in the alloy is substantially reduced.

3.    A nickel base superalloy, particularly suited for directional recrystallization, the composition of which includes from about 0.010 to about 0.015% boron.

4. A nickel base superalloy, particularly adapted to be directionally recrystallized which consists of:

| | | | |
|---|---|---|---|
| 3% | to | 7.2% | Al |
| up | to | 1.0% | Ti |
| up | to | 10.0% | W |
| up | to | 12.0% | Mo |
| up | to | 9.0% | Ta |
| up | to | 1.0% | Cb |
| up | to | 5.0% | Co |
| 5.0% | to | 12.0% | Cr |
| up | to | 0.5% | Hf |
| up | to | 0.05% | Y |
| up | to | 0.01% | C |
| 0.010% | to | 0.015% | B |
| up | to | 0.010% | Zr |
| 5.0% | to | 15.0% | (W+Mo+Ta+Cb) |
| balance essentially | | | Ni. |

5. In the method of directionally recrystallizing nickel base superalloys the improvement which comprises:

incorporating boron in the alloy in an amount of from at least about .010 but insufficient to cause incipient melting, whereby the incidence of twinning in the alloy is substantially reduced.

*FIG. 1*

100 X

*FIG.2*

50 X

FIG. 3

200 X